## Europäisches Patentamt
## European Patent Office
## Office européen des brevets

(19)

(11) Veröffentlichungsnummer : **0 021 025**
**B1**

(12) **EUROPÄISCHE PATENTSCHRIFT**

(45) Veröffentlichungstag der Patentschrift : 19.05.82

(21) Anmeldenummer :.80102766.5

(22) Anmeldetag : 20.05.80

(51) Int. Cl.³ : **H 01 L 29/91**

(54) **Schottky-Dioden-Anordnung.**

(30) Priorität : 03.07.79 DE 2926756

(43) Veröffentlichungstag der Anmeldung :
07.01.81 (Patentblatt 81/01)

(45) Bekanntmachung des Hinweises auf die Patenterteilung : 19.05.82 Patentblatt 82/20

(84) Benannte Vertragsstaaten :
FR GB IT NL

(56) Entgegenhaltungen :
FR - A - 1 064 044
FR - A - 1 336 812
FR - A - 2 031 421

(73) Patentinhaber : Licentia Patent-Verwaltungs-GmbH
Theodor-Stern-Kai 1
D-6000 Frankfurt/Main 70 (DE)

(72) Erfinder : Dahlberg, Reinhard, Dr.
Innere Bergstrasse 32
D-7101 Flein (DE)

(74) Vertreter : Maute, Hans-Jürgen, Dipl.-Ing. et al
Licentia Patent-Verwaltungs-GmbH Theo-
dor-Stern-Kai 1
D-6000 Frankfurt/Main 70 (DE)

Imprimerie Jouve, 18, rue St-Denis, 75001 Paris, France

## Schottky-Dioden-Anordnung

Die Erfindung beschreibt eine Schottky-Dioden-Anordnung, bei welcher mehrere kleinflächige Metall-Halbleiter-Kontakte zu einem mechanisch stabilen Bauelement vereinigt sind.

Neben einigen Nachteilen haben Schottky-Dioden bekanntlich auch einige Vorteile gegenüber p/n-Dioden. Sie lassen sich relativ einfach herstellen, haben kleine Schaltzeiten und können auch mit relativ kleinen Torspannungen hergestellt werden. Als Mischer-Dioden sind Schottky-Dioden in den letzten Jahren für immer höhere Arbeitsfrequenzen hergestellt worden. Mit Dioden-Durchmessern von $5.10^{-5}$ cm sind Frequenzen bis über 4 THz erreicht worden (1). Diese Schottky-Dioden sind eine ernsthafte Konkurrenz für Metall-Oxyd-Metall-(MOM) Punkt-Kontakt-Dioden, weil sie in Planar-Technik aufgebaut sind, und dadurch eine größere mechanische Stabilität aufweisen. Dafür ist ihre Herstellung aufwendiger.

Der Erfindung liegt die Aufgabe zugrunde, eine Schottky-Dioden-Anordnung anzugeben, die mechanisch stabil ist und bis zu extrem hohen Frequenzen und auch für große Leistungen ausgebildet werden kann. Diese Aufgabe wird erfindungsgemäß dadurch gelöst, daß eine Platte oder Scheibe aus metallisch leitendem Material und eine Platte oder Scheibe aus Halbleitermaterial vorgesehen sind, daß mindestens eine Platte oder Scheibe auf einer ihrer beiden Seiten eine Struktur mit mindestens drei Erhebungen aufweist, und daß die Platten oder Scheiben unter Druck so zusammengesetzt sind, daß durch die Erhebungen elektrisch parallel geschaltete Druck-Kontakte zwischen ihnen gebildet sind. Diese elektrisch parallelen Druck-Kontakte sind vorzugsweise flächengleich.

In einem bevorzugten Ausführungsbeispiel der Erfindung besteht die Struktur aus parallelen Wällen. Die zwei Platten oder Scheiben werden mit ihren strukturierten Oberflächenseiten unter Druck so zusammengesetzt, daß die parallelen Wälle in der Struktur beider Platten oder Scheiben sich kreuzen und eine regelmäßige flächenhafte Verteilung von elektrisch parallel geschalteten Druck-Kontakten bilden. Wenn N die Anzahl der parallel verlaufenden Wälle in der Struktur jeder Scheibe ist, dann entstehen zwischen den beiden Platten oder Scheiben $N^2$ Druck-Kontakte. Das Prinzip der gekreuzten parallelen Wälle ist bereits in der deutschen Offenlegungsschrift DE-A-25 47 262 beschrieben worden. Es wird jedoch in DE-A-25 47 262 nicht dargelegt, daß und wie mit diesem Prinzip Schottky-Dioden hergestellt werden können.

Die Platte oder Scheibe aus metallisch leitendem Material kann aus Metall, einer Legierung oder einer metallisch leitenden Verbindung bestehen.

Die Platte oder Scheibe aus Halbleiter-Material kann aus einem n- oder p-leitendem einkristallinen oder polykristallinen Element-Halbleiter oder Verbindungshalbleiter bestehen.

Die Platte oder Scheibe aus Halbleitermaterial kann erfindungsgemäß auch mit einer Isolatorschicht überzogen sein, deren Dicke kleiner als $1.10^{-6}$ cm ist. Als Isolatormaterial kann chemisches Oxyd, thermisches Oxyd, elektrolytisches Oxyd, pyrolytisches Oxyd, Nitrid u.a. verwendet sein.

Der Zwischenraum zwischen den Erhebungen der Struktur kann evakuiert sein, so daß die beiden Platten oder Scheiben durch den atmosphärischen Druck zusammengepreßt sind.

Mehrere Schottky-Dioden-Anordnungen können auch elektrisch in Serie geschaltet sein.

Im folgenden wird die Erfindung in 5 Ausführungsbeispielen näher beschrieben.

Ausführungsbeispiel 1 beschreibt eine Prinzip-Darstellung mit einer Siliziumscheibe.

Ausführungsbeispiel 2 beschreibt eine $n^+$-GaAs Mischer-Dioden-Anordnung für höchste Frequenzen.

Ausführungsbeispiel 3 beschreibt eine $n^+$-GaAs Mischer-Diode mit dünner Oxydschicht.

Ausführungsbeispiel 4 beschreibt eine n-Silizium-Schottky-Diode mit kleiner Torspannung.

Ausführungsbeispiel 5 beschreibt eine Schottky-Dioden-Anordnung als Mikrophon.

Ausführungsbeispiel 1

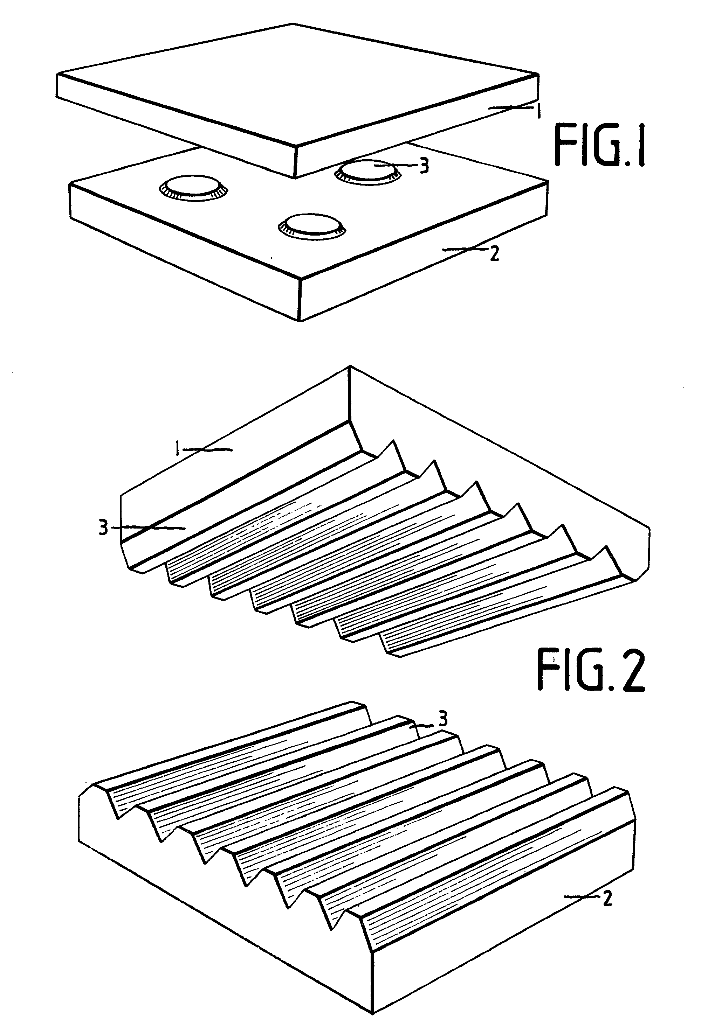

In Fig. 1 ist 1 eine Nickelscheibe. 2 ist eine n-Siliziumscheibe, welche drei gleichgroße kegelförmige Erhebungen 3 trägt, welche über einen Ätzprozess hergestellt sind. Nach dem Zusammenlegen der beiden Scheiben 1 und 2 bilden die drei Erhebungen 3 Schottky-Kontakte zwischen den Scheiben 1 und 2.

Ausführungsbeispiel 2

In Fig. 2 ist 1 eine Wolframplatte, auf welcher einseitig über einen elektrolytischen Ätzprozess parallel verlaufende Wälle 3 erzeugt sind. Die Wälle 3 verjüngen sich zur Stirnfläche hin und weisen dort eine Breite von $1.10^{-5}$ cm auf. Die Wälle 3 sind mit einer $5.10^{-6}$ cm dicken Platin-Schicht überzogen. 2 ist eine $n^+$-GaAs-Scheibe, welche ebenfalls auf einer Seite eine Struktur mit parallel verlaufenden Wällen 3 hat. Auch diese Wälle 3 verjüngen sich und haben an der Stirnfläche eine Breite von $1.10^{-5}$ cm. Die Scheibe 1 wird — bezogen auf die Wallstrukturen — um den Winkel $\alpha = 90°$ gedreht auf die Scheibe 2 mit definiertem Druck so aufgesetzt und fixiert, daß die sich berührenden und kreuzenden Wälle auf den beiden Scheiben kleinflächig Schottky-Kontakte bilden.

Die jeweils sieben parallelen Wälle auf den Scheiben 1 und 2 erzeugen dabei neunundvierzig elektrisch parallel geschaltete Schottky-Kontakte mit einer Einzelfläche von ca. $1.10^{-10}$ cm². Diese Schottky-Dioden-Anordnung hat sehr kleine parasitäre Impedanzen und ist bis zu höchsten Frequenzen als Mischer verwendbar.

Ausführungsbeispiel 3

In der Schnittdarstellung der Fig. 3a ist 1 eine Kupferplatte, welche einseitig eine Struktur mit sich verjüngenden parallelen Wällen 3 (siehe Fig. 2) hat. Die Stirnfläche der Wälle 3 ist $5 . 10^{-5}$ cm breit. Die Kupferplatte 1 ist mit einer Goldschicht 5 überzogen, die $2 . 10^{-5}$ cm dick ist. 1* ist eine Aluminiumplatte, welche einseitig die gleiche Struktur paralleler Wälle 3 hat wie 1. Zwischen den strukturierten Oberflächen der beiden metallischen Platten 1 und 1* befindet sich eine $n^+$-GaAs-Scheibe 2, welche mit $3 . 10^{18}$ Sn-Atomen/cm³ dotiert ist. Diese GaAs-Scheibe 2 trägt auf beiden Seiten die gleiche Struktur paralleler Wälle 3 wie die Platten 1 und 1*. Durch einen chemischen Oxydationsprozeß wurde die $n^+$-GaAs-Scheibe mit einer Oxydschicht 6 überzogen, deren Dicke ca. $1 . 10^{-7}$ cm ist. Die $n^+$-GaAs-Scheibe 2 wird bezogen auf die Strukturen in den Platten 1 und 1* um 90° verdreht zwischen die strukturierten Seiten der Platten 1 und 1* gelegt und unter definiertem Druck zusammengehalten. Die Schottky-Kontakte werden durch die Berührungsflächen der sich kreuzenden Wälle auf den Platten 1 und 2 gebildet Zischen der Platte 1* und 2 kommen entsprechende nicht sperrende Kontakte zustande.

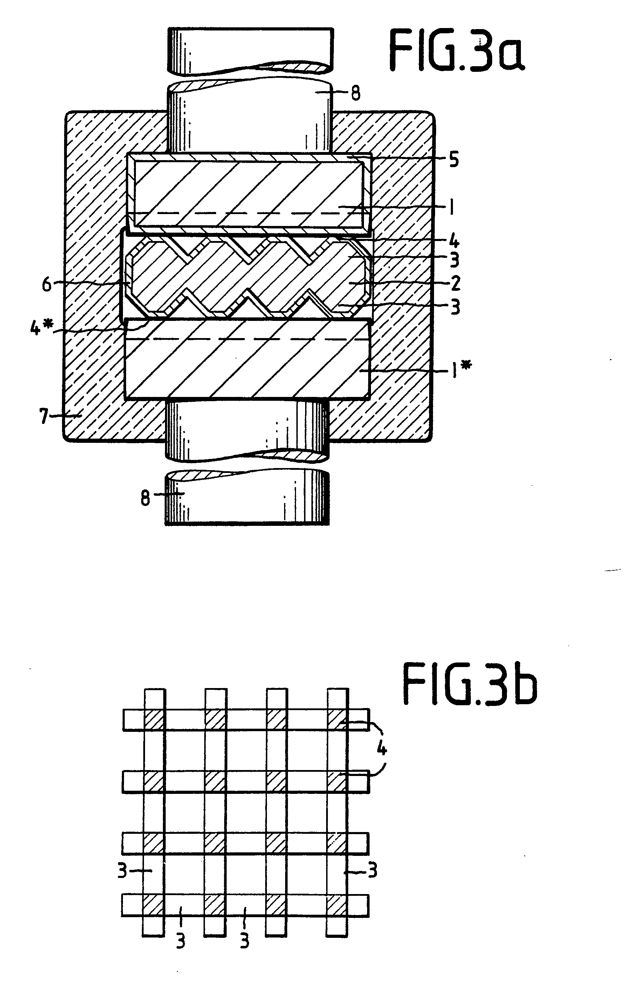

Fig. 3b zeigt in einer Darstellung der Berührungsebene die sechzehn sperrenden Schottky-Kontakte 4 zwischen der Platte 1 und der GaAs-Scheibe 2, denen nicht sperrende Kontakte 4* (Fig. 3a) zwischen der Platte 1* und der GaAs-Scheibe 2 entsprechen. 7 in Fig. 3a ist ein die Schottky-Dioden-Anordnung enthaltendes Keramikgehäuse, welches zwei koaxiale Diodenanschlüsse 8 an die Metallplatten 1 und 1* hat.

Ausführungsbeispiel 4

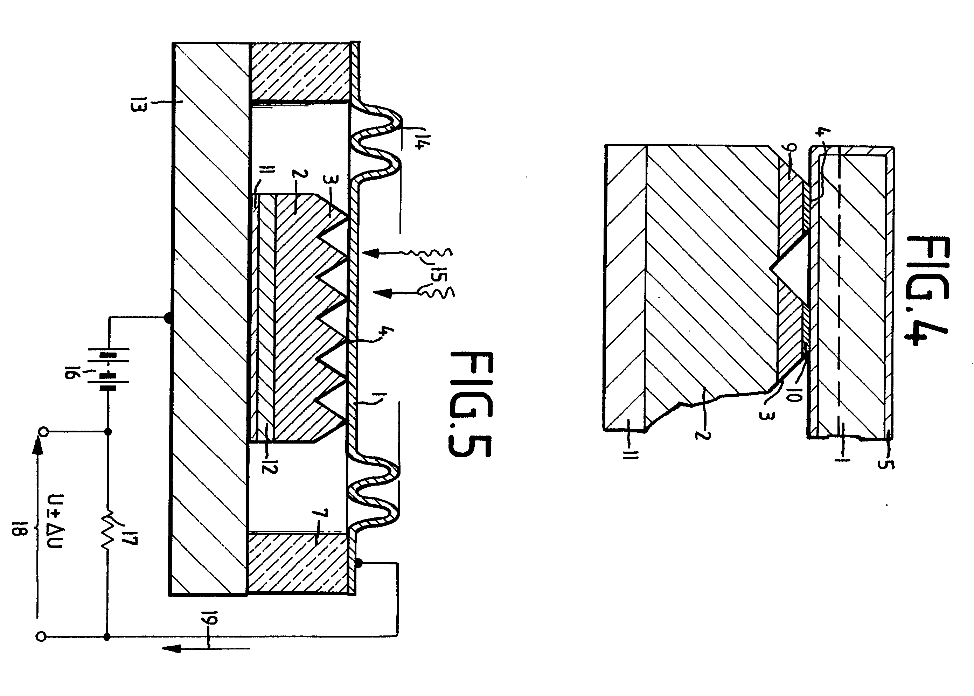

In der Schnittdarstellung der Fig. 4 ist 1 eine Kupferscheibe, welche einseitig eine Struktur mit parallelen in Richtung der Bildebene verlaufenden Wällen 3 (siehe entsprechende Darstellung Fig. 2) trägt, welche sich auf einen Durchmesser an der Stirnseite von $5 . 10^{-4}$ cm verjüngen. Die Kupferscheibe 1 ist mit einer Nickel-Schicht 5 von $2 . 10^{-4}$ cm Dicke überzogen. 2 ist eine $n^+$-Siliziumscheibe, auf welche eine $n^-$-silizium-Epitaxschicht 9 mit einem spezifischen Widerstand von 20 Ωcm und einer Dicke von $1 . 10^{-3}$ cm aufgebracht wurde. In diese Epitax-Schicht 9 ist eine n-Diffusionsschicht 10 mit einer Oberflächenkonzentration von $5 . 10^{17}$/cm³ mit einer Diffusionstiefe von $1 . 10^{-5}$ cm eingebracht. Danach ist in die Siliziumscheibe 2 eine Struktur mit parallelen Wällen 3, die sich an der Stirnfläche auf $5 . 10^{-4}$ cm verjüngen, eingebracht worden. Durch Aufeinanderlegen der bezüglich der Wallstrukturen gegeneinander in der Scheibenebene in der dargestellten Weise verdrehten beiden Scheiben 1 und 2 entsteht unter mechanischem, auf die Scheiben einwirkenden Druck eine regelmäßige flächenhafte Verteilung von elektrisch parallel geschalteten Schottky-Kontakten 4. Die Torspannung dieser Schottky-Dioden-Anordnung wird durch die dünne n-Siliziumschicht 10 reduziert. 11 ist ein Metallkontakt an der Siliziumscheibe 2.

Zur Erhöhung der Sperrspannung können mehrere derartiger Schottky-Dioden-Anordnungen elektrisch in Serie geschaltet sein.

Ausführungsbeispiel 5

In der Schnittdarstellung der Fig. 5 hat die n-Siliziumscheibe 2 auf einer Seite eine Struktur von gleichgroßen kegelförmigen Erhebungen 3, die an der Spitze einen Krümmungsradius von $2 . 10^{-4}$ cm haben. 1 ist eine Membrane aus Federstahl mit einer Dicke von $2,5 . 10^{-3}$ cm. Sie ist über eine elastische Faltung 14 an dem die Halbleiteranordnung enthaltenden Keramik-Gehäuse 7 befestigt und liegt an ihrer Unterfläche mit leichtem Druck auf den Spitzen der kegelförmigen Erhebungen 3 auf. 12 ist eine $n^+$-Schicht in der n-Siliziumscheibe 2 auf der den Erhebungen gegenüberliegenden Oberflächenseite und 11 ist ein metallischer Kontakt an dieser $n^+$-Schicht 2, die die Verbindung zu einer metallischen Bodenplatte 13 des Gehäuses herstellt. Über den elektrischen Widerstand 17 erzeugt die Batterie 16 über die Anschlüsse 1 und 13 eine Sperrspannung an den Schottky-Kontakten 4 zwischen der n-Siliziumscheibe 2 und der Membrane 1. Durch die Druckschwankungen 15, die auf die Membrane 1 einwirken, wird der die Anordnung durchfließende Dioden-Sperrstrom 19 als Spannungsschwankung 18 am Widerstand 17 registriert.

Literatur

(1) D.T. Hodges and M. McColl
« Extension of the Schottky barrier detector 70 μm (4,3 THz) using submicron-dimensional contacts » Appl. Phys. Letters. *30*, 5-7 (1977).

Bezugsziffern

1 Platte oder Scheibe aus metallisch leitendem Material
2 Platte oder Scheibe aus Halbleitermaterial
3 Erhebungen
4 Druck-Kontakt
5 Nickel- bzw. Gold-Schicht
6 Isolatorschicht
7 Keramik-Gehäuse
8 koaxiale Dioden-Anschlüsse
9 $n^-$-Si-Schicht
10 n-Si-Schicht
11 Metall-Kontaktschicht
12 $n^+$-Si-Schicht
13 metallische Bodenplatte
14 elastische Faltung
15 Schallwellen
16 Batterie
17 elektrischer Widerstand

18 Klemmen zur Abnahme des Ausgangssignals

19 Sperrstrom

**Ansprüche**

1. Schottky-Dioden-Anordnung, dadurch gekennzeichnet, daß eine Platte oder Scheibe aus metallisch leitendem Material (1) und eine Platte oder Scheibe aus Halbleitermaterial (2) vorgesehen sind, daß mindestens eine Platte oder Scheibe auf einer ihrer beiden Seiten eine Struktur mit mindestens drei Erhebungen (3) aufweist, und daß die Platten oder Scheiben (1, 2) unter Druck so zusammengesetzt sind, daß durch die Erhebungen (3) elektrisch parallel geschaltete Schottky-Druck-Kontakte zwischen Ihnen gebildet sind.

2. Schottky-Dioden-Anordnung nach Anspruch 1, dadurch gekennzeichnet, daß die elektrisch parallel geschalteten Druck-Kontakte (4) flächengleich sind.

3. Schottky-Dioden-Anordnung nach einem der vorhergehenden Ansprüche, dadurch gekennzeichnet, daß die Struktur aus parallelen Wällen (3) besteht, und daß zwei Scheiben (1, 2) mit dieser Struktur so zusammengesetzt werden, daß die Wälle (3) sich kreuzen und eine regelmäßige flächenhafte Verteilung von elektrisch parallelen Druck-Kontakten (4) zwischen den zwei getrennten Platten oder Scheiben (1, 2) bilden.

4. Schottky-Dioden-Anordnung nach einem der vorhergehenden Ansprüche dadurch gekennzeichnet, daß als metallisch leitendes Material Metall, eine Metall-Legierung oder ein entartet dotierter Halbleiter vorgesehen ist.

5. Schottky-Dioden-Anordnung nach einem der vorhergehenden Ansprüche, dadurch gekennzeichnet, daß als Halbleitermaterial einkristalline oder polykristalline n- oder p-leitende Elementhalbleiter oder Verbindungshalbleiter vorgesehen.

6. Schottky-Dioden-Anordnung nach einem der vorhergehenden Ansprüche, dadurch gekennzeichnet, daß die Platte oder Scheibe (2) aus einkristallinem oder polikristallinem Halbleiter mit einer Isolatorschicht (6) überzogen ist, deren Dicke kleiner als $1 . 10^{-6}$ cm ist, und daß als Isolatormaterial anodisches oder thermisches Oxyd, $SiO_2$, Nitride oder andere Verbindungen vorgesehen sind.

7. Schottky-Dioden-Anordnung nach einem der vorhergehenden Ansprüche, dadurch gekennzeichnet, daß der Zwischenraum zwischen den Platten oder Scheiben (1, 2) evakuiert ist, und daß der mechanische Druck durch den atmosphärischen Außendruck ausgeübt wird.

8. Schottky-Dioden-Anordnung nach einem der vorhergehenden Ansprüche, dadurch gekennzeichnet, daß mehrere Schottky-Dioden-Anordnungen in Serie geschaltet sind.

**Claims**

1. A Schottky diode arrangement, characterised in that a plate or disc made from metallically conducting material (1) and a plate or disc from semiconductor material (2) are provided ; that at least one plate or disc has on one of its two sides a structure with at least three elevations (3) ; and that the plates or discs (1, 2) are put together under pressure so that electrically parallel Schottky pressure contacts are formed between them by the elevations (3).

2. A Schottky diode arrangement according to Claim 1, characterised in that the electrically parallel pressure contacts (4) have the same area.

3. A Schottky diode arrangement according to any one of the preceding claims, characterised in that the structure comprises parallel ridges (3) ; and that two discs (1, 2) having this structure are put together so that the ridges (3) intersect and form a regular distribution in terms of area of electrically parallel pressure contacts (4) between the two separate plates or discs (1, 2).

4. A Schottky diode arrangement according to any one of the preceding claims, characterised in that a metal alloy or a degenerated doped semiconductor is provided as the metallically conductive material.

5. A Schottky diode arrangement according to any one of the preceding claims, characterised in that monocrystalline or polycrystalline n- or p-conductive element semiconductors or compound semiconductors are provided as the semiconductor material.

6. A Schottky diode arrangement according to any one of the preceding claims, characterised in that the plate or disc (2) made from a monocrystalline or polycrystalline semiconductor is coated with an insulating layer (6), the thickness of which is less than $1 . 10^{-6}$ cm ; and that an anodic or thermal oxide, $SiO_2$, nitrides or other compounds, are provided as the insulator material.

7. A Schottky diode arrangement according to any one of the preceding claims, characterised in that the intermediate space between the plates or discs (1, 2) is evacuated and that the mechanical pressure is applied by the external atmospheric pressure.

8. A Schottky diode arrangement according to one of the preceding claims, characterised in that several Schottky diode arrangements are connected in series.

**Revendications**

1. Réseau de diodes Schottky, caractérisé en ce qu'une plaquette ou pastille de matériau à conduction métallique (1) et une plaquette ou pastille de matériau semiconducteur (2) sont prévues ; une plaquette ou pastille au moins présente sur une de ses deux faces une structure de trois bossages (3) au moins ; et les plaquettes ou pastilles (1, 2) sont assemblées sous pression, de façon que les bossages (3) forment entre elles des contacts de Schottky par compression, couplés électriquement en parallèle.

2. Réseau de diodes Schottky selon revendication 1, caractérisé en ce que les contacts par compression (4) couplés électriquement en parallèle présentent une même surface.

3. Réseau de diodes Schottky selon une des revendications 1 et 2, caractérisé en ce que la structure est constituée par des protubérances (3) parallèles ; et deux pastilles (1, 2) présentent cette structure sont assemblées de façon que les protubérances (3) se croisent en formant une répartition superficielle régulière de contacts par compression (4) électriquement en parallèle entre les deux plaquettes ou pastilles (1, 2).

4. Réseau de diodes Schottky selon une quelconque des revendications 1 à 3, caractérisé par l'emploi d'un métal, d'un alliage métallique ou d'un semiconducteur dopé dégénéré comme matériau à conduction métallique.

5. Réseau de diodes Schottky selon une quelconque des revendications 1 à 4, caractérisé par l'emploi d'un élément semiconducteur ou d'un composé intermétallique n ou p, monocristallin ou polycristallin, comme matériau semiconducteur.

6. Réseau de diodes Schottky selon une quelconque des revendications 1 à 5, caractérisé en ce que la plaquette ou pastille (2) de semiconducteur monocristallin ou polycristallin est recouverte d'une couche isolante (6) d'épaisseur inférieure à $1.16^{-6}$ cm ; et un oxyde anodique ou thermique, $SiO_2$, des nitrures ou d'autres composés sont utilisés comme matériau isolant.

7. Réseau de diodes Schottky selon une quelconque des revendications 1 à 6, caractérisé en ce que l'espace compris entre les plaquettes ou pastilles (1, 2) est mis sous vide, et la pression mécanique est exercée par la pression atmosphérique extérieure.

8. Réseau de diodes Schottky selon une quelconque des revendications 1 à 7, caractérisé par le couplage en série de plusieurs réseaux de diodes Schottky.

FIG.1

FIG.2

FIG.3a

FIG.3b

# FIG.4

# FIG.5

$U \pm \Delta U$